# EUROPEAN PATENT SPECIFICATION

(11) **EP 0 381 437 B1**
(45) Date of publication and mention of the grant of the patent: **12.06.1996**
(21) Application number: 90300942.1
(22) Date of filing: 30.01.1990
(51) Int. Cl.: C23C 14/35, H01J 37/34

(54) **Magnetron sputtering apparatus**
Magnetronzerstäubungsanlage
Dispositif de pulvérisation magnétron

(30) Priority: 30.01.1989 JP 17704/89
(43) Date of publication of application: 08.08.1990
(60) Divisional application: 94117736.2
(73) Proprietor: Mitsubishi Chemical Corporation, Chiyoda-ku Tokyo (JP)
(72) Inventor: Arita, Yoji, Yokohama-shi, Kanagawa-ken (JP)
(74) Representative: Rackham, Anthony Charles

(56) References cited:
- US-A- 4 265 729
- US-A- 4 448 653

## Description

The present invention relates to a magnetron sputtering apparatus and, more particularly, to a magnetron sputtering apparatus capable of readily retaining plasma in a stable manner even in case of a large-scale magnetron or in case where target of a ferromagnetic material is sputtered. The present invention also relates to a magnetron sputtering apparatus in which local erosion of the target is blocked, thereby prolonging life of the target, and in which a variation in a sputtering rate can be made to an extremely small extent during operation.

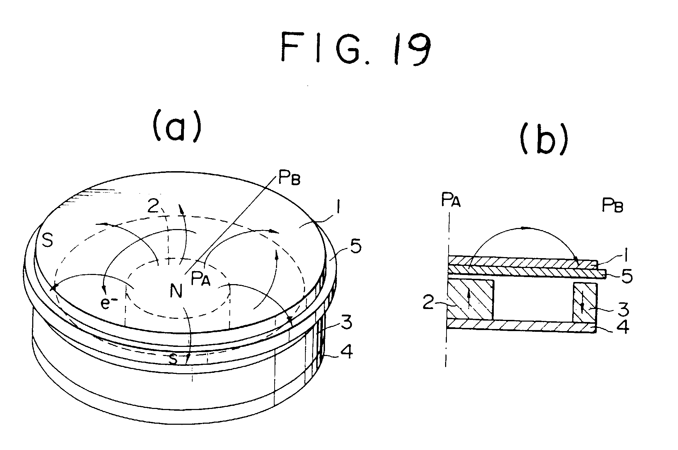

A conventional magnetron sputtering device will be described with reference to FIG. 19, in which FIG. 19(a) is a perspective view showing such a magnetron sputtering device and FIG. 19(b) is a cross-sectional view showing the magnetron sputtering device taken along line P_{A}- P_{B} of FIG. 19(a). As shown in FIG. 19, reference numeral 1 denotes target composed of a non-magnetic material or a ferromagnetic material. On the back side of the target 1 are disposed an inner magnetic pole 2 and an outer magnetic pole 3 disposed so as to enclose the inner magnet 2 and having polarity opposite to that of the inner magnetic pole 2. To their bottom portions is connected a magnetic yoke 4 composed usually of a magnetic material such as steel or the like.

The sputtering device having the foregoing configuration is accommodated in a vacuum container. When the magnetron sputtering device is in use, the container is filled with argon gas at low pressures and voltage is applied between the target and a substrate (not shown), such as a disc, thereby ionizing the argon gas and generating electrons from the target surface. The argon ions bombard the target to cause the target substance to be generated and to form a thin film on a surface of the substrate. The magnetic field formed by the two magnetic poles 2 and 3 can effectively catch the electrons and promote ionization of the argon gas, thereby improving the effectiveness of sputtering.

For conventional magnetron sputtering devices having the configuration described hereinabove, it is considered that the electrons caught around the surface of the target 1 are enclosed by the magnetic field formed in the shape of a semi-circular dome as indicated by arrows in Fig. 19(a) and move along the dome-like magnetic field configuration. Thus, occurrence of erosion on the surface of the target 1 depends upon distribution of the magnetic field over the upper surface of the target 1, in other words, upon the distribution of the horizontal component and the vertical component of the magnetic field, with respect to the surface of the target. The term "vertical" is herein used to refer to a direction perpendicular to the plane of the target, and the term "horizontal" to a direction parallel to the plane of the target.

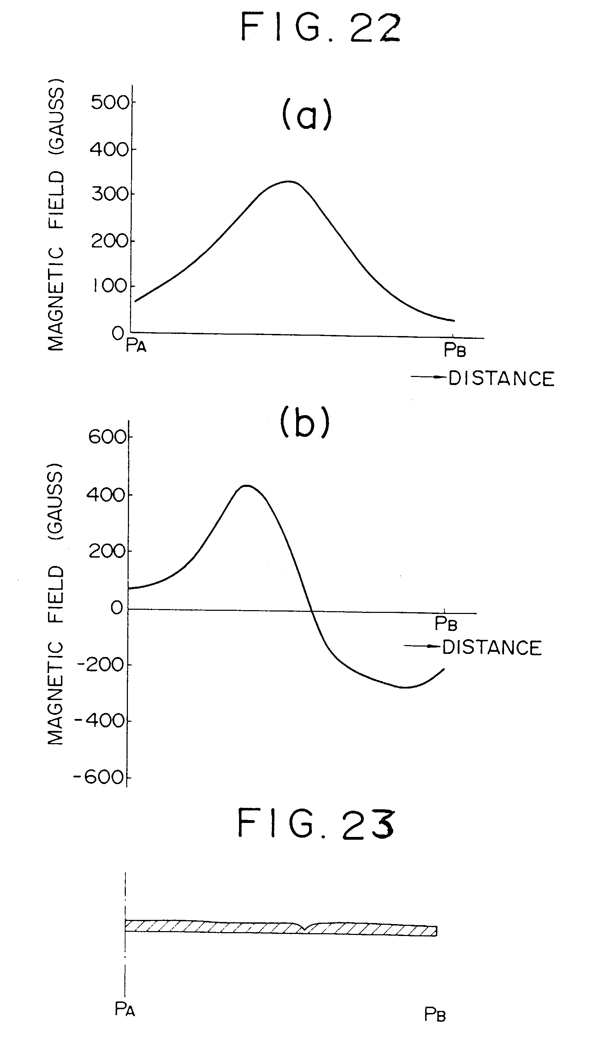

Fig. 21 is a cross-sectional view showing a typical erosion pattern of the target 1 in the region between P_{A} - P_{B} of Fig. 19(a) when a ferromagnetic material such as iron or cobalt, is used as the target. As is understood from this drawing, erosion develops locally and the life of the target 1 is shortened considerably.

Several solutions to this problem have been proposed. One of the solutions is to provide a large number of grooves on the target 1 extending in its longitudinal direction to thereby generate the horizontal component of the magnetic field over a full surface of the target 1 ("GT Target": Journal of Nippon Kinzoku Gakkai, Vol. 1, No. 25, p. 562, 1986). This technique, however, presents the disadvantage that formation of a large number of the longitudinal grooves on the target 1 is laborious.

We have found that a site where erosion mainly develops corresponds well to the position where the polarity of the vertical component of the magnetic field varies rather than the distribution of intensity of the horizontal component thereof, namely, to the position where the value of the vertical component thereof is very small. This is considered to be based on the fact that, as shown in Fig. 19(a), the electrons are moving in a cycle along the dome-like magnetic field over the surface of the target 1 as well as, at the same time, making a periodical movement in the direction of gradient in the vertical magnetic field. The number of electrons available to ionize argon gas atoms increases where the vertical component of the magnetic field becomes small. When a ferromagnetic material is used as the target, if erosion of the target 1 occurs, the leakage magnetic field becomes larger as shown in Fig. 21 and the gradient of the vertical magnetic field becomes larger at the location where erosion occurs, so that the intensity of the horizontal magnetic field increases, thereby further accelerating local erosion. If it is difficult to ensure the intensity of the magnetic field on the target in the case of conventional large-scale magnetron sputtering devices and sputtering devices using ferromagnetic target, there are many occasions in which an electromagnet is used for the inner and outer magnetic poles. In those occasions, however, the electromagnet presents the disadvantages that it is expensive in operating costs and the application of electricity is accompanied by the generation of heat, so that it cannot readily be applied for any device.

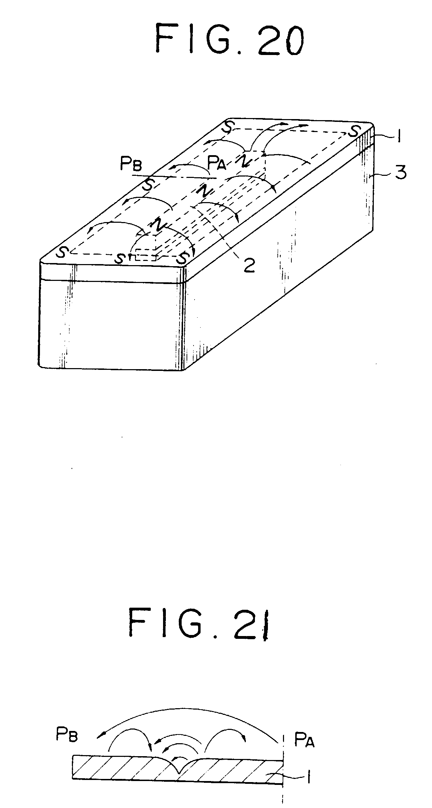

For the above reason, permanent magnets are desired. As the magnetic flux generally spreads over the target from the inner magnetic pole to the outer magnetic pole, the magnetic flux density around the outer magnetic pole 3 tends to be decreased compared with that around the inner magnetic pole. Thus, it is required that the magnetic flux density of the outer magnetic pole 3 be made larger in order to keep plasma on the target stable. It is to be noted that the outer magnetic pole required for increasing the magnetic flux density comprises the total outer periphery of the magnetron in a semi-circular shape as shown in Fig. 19(a) or it is a portion of the outer magnetic pole 3 for a magnetron in a rectangular shape as shown in Fig. 20, where the magnetic flux spreads in a radial form from the inner magnetic pole 2 to the outer magnetic pole 3. When the soft magnetic material or permanent magnet is used between the inner and outer magnetic poles in order to control the distribution of the magnetic field over the target as with the present invention, this technology is particularly significant because the intensity of the magnetic field over the target is decreased. In either case, it is required that the magnetic flux density over the inner and outer magnetic poles be increased to a sufficiently high level in order to retain the plasma on the upper surface of the target in a stable manner. When the target is of a ferromagnetic material, the technique of sticking a magnet to an outer side surface of the outer magnetic pole 3 becomes significant in order to keep the high magnetic field over the upper surface of the target because the magnetic flux decreases over the upper surface of the target. For magnetrons disclosed in U.S. Patent Nos. 4,162,954 and 4,265,729, which are proposed for improvement in the distribution of erosion of the target, like the present invention, magnets are disposed such that centralization of the magnetic flux around the inner magnetic pole is prevented in order to make the magnetic lines of force as parallel as possible to the target surface over the target and the vertical component of the magnetic field is not rendered large around the inner magnetic pole. Such magnetrons present the drawbacks that plasma is likely to become unstable and, when the target is of the ferromagnetic material, the leakage magnetic field over the target surface becomes so small that no plasma is caused at all to occur.

US-A-4 265 729 discloses a magnetron sputtering apparatus comprising an inner magnetic pole, an outer magnetic pole having a polarity opposite to that of the inner magnetic pole and arranged to surround the inner magnetic pole, and a target disposed at least above the inner magnetic pole and extending therefrom towards the outer magnetic pole, each of the magnetic poles comprising a permanent magnet having magnetization in a direction perpendicular to the plane of the target of a soft magnetic material, and a first permanent magnet having magnetization in a direction parallel to the plane of the target is disposed between the inner and outer magnetic poles.

The invention is characterised in that a second permanent magnet having magnetization predominantly in a direction opposite to the direction of the magnetization in the first permanent magnet is disposed on an outer side of the outer magnetic pole.

The invention permits magnetron sputtering apparatus to be constructed which can retain plasma on the target in a stable manner, which prevents local erosion of the target, which can significantly prolong life of the target, and which can sputter the target at a stable sputtering rate during operation, particularly when ferromagnetic material is used as the target.

Preferred embodiments of apparatus further comprise means disposed between the first permanent magnet and the target and adapted: (a) to decrease, at a central portion between the inner and outer magnetic poles, a vertical (as defined) component of a leakage magnetic field generated by the inner and outer magnetic poles and emerging from the source of the target; (b) to increase the said vertical component thereof at a portion around the magnetic poles; and (c) to cause the distribution of intensity of the horizontal (as defined) component of the magnetic field between the magnetic poles to adopt an M-shaped form, having peaks towards the magnetic poles and a trough therebetween.

Most preferably, said means comprises a soft magnetic material divided into plural discrete sections by a substance having a narrow width and a low permeability, or by slits, the number of the sections of the soft magnetic material and the width of the low permeability substance or the slits being determined in accordance with the magnetic characteristics or the thickness of the target. The number of the sections of the soft magnetic material and the width of the less permeable substance or the slits are optimized in order to optimize the distribution of the magnetic field over the target so as to correspond to magnetic characteristics or the thickness of the target.

In other embodiments, the distributing means is composed of soft magnetic material having a cross-sectional area which is larger at its middle portion and gets gradually smaller towards its end portions, or alternatively is of curved shape, and is disposed such that its curved end portions are further from the target than its central portion. In yet further embodiments, the means may be composed of a permanent magnet which has magnetization predominantly in the horizontal direction and which is lower in height at its middle portion and becomes gradually higher towards its end portions, in other words which is arranged such that its central portion comes closer to the target and its end portions are farther therefrom.

The invention is hereinafter described in more detail by way of example only with reference to the accompanying drawings, in which:-
Fig. 1 and Figs. 2(a), 2(b), 2(c) are cross-sectional views showing portions of embodiments of apparatus according to the present invention;
Figs. 3(a) and 3(b) are graphs showing the distributions of horizontal and vertical components respectively of the magnetic field over the target in a first example of apparatus according to the invention in which the target is of a ferromagnetic material;
Fig. 4 is a cross-sectional view showing an erosion pattern of the target in said first example of apparatus according to the invention;
Figs. 5(a) and 5(b) are graphs showing the distributions of horizontal and vertical components respectively of the magnetic field over the target in a second example of apparatus according to the invention in which the target is of a ferromagnetic material;
Fig. 6 is a cross-sectional view showing an erosion pattern of the target in said second example of apparatus according to the invention;
Figs. 7(a) and 7(b) are graphs showing the distributions of horizontal and vertical components respectively of the magnetic field over the target in a third example of apparatus according to the invention, in which the target is of a non-magnetic material;
Fig. 8 is a cross-sectional view showing an erosion pattern of the target in said third example of apparatus according to the invention;
Figs. 9(a) and 9(b) are graphs showing the distributions of horizontal and vertical components respectively of the magnetic field over the target in a fourth example of apparatus according to the invention, in which the target is of a non-magnetic material;
Fig. 10 is a cross-sectional view showing an erosion pattern of the target in said fourth example of apparatus according to the invention;
Figs. 11(a) and 11(b) are graphs showing the distributions of horizontal and vertical components respectively of the magnetic field over the target in a fifth example of apparatus according to the invention, in which the target is of a non-magnetic material;
Fig. 12 is a cross-sectional view showing an erosion pattern of the target in said fifth example of apparatus according to the invention;
Figs. 13 - 16 are cross-sectional views showing portions of preferred embodiments of apparatus having means for controlling the distribution of magnetic field over the target surface, said means being composed of soft magnetic material;
Figs. 17 - 18 are cross-sectional views showing portions of preferred embodiments of apparatus having means for controlling the distribution of magnetic field over the target surface, said means being composed of permanent magnetic material;
Figs. 19(a) and (b) are, respectively, a perspective view showing a conventional round magnetron, and a cross-sectional view showing the same magnetron taken along line P_{A} - P_{B} of Fig. 20(a);
Fig. 20 is a perspective view showing a conventional rectangular magnetron;
Fig. 21 is a cross-sectional view showing a typical erosion pattern formed when a ferromagnetic target is sputtered using a conventional magnetron;
Figs. 22(a) and 22(b) are graphs showing the distributions of horizontal and vertical components respectively of the magnetic field over the target of a conventional magnetron, in which the target is of ferromagnetic material;
Figs. 23 is a cross-sectional view showing an erosion pattern formed in a conventional magnetron having a target of ferromagnetic material;
Figs. 24(a) and 24(b) are graphs showing the distributions of horizontal and vertical components respectively of the magnetic field over the target of a conventional magnetron having a target of a non-magnetic material; and
Fig. 25 is a cross-sectional view showing an erosion pattern formed in a conventional magnetron having a target of a non-magnetic material.

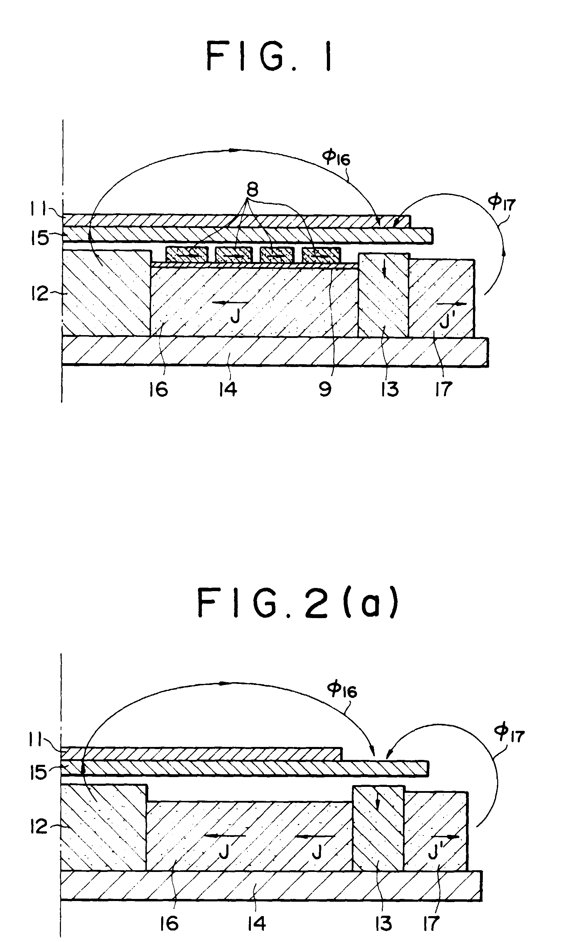

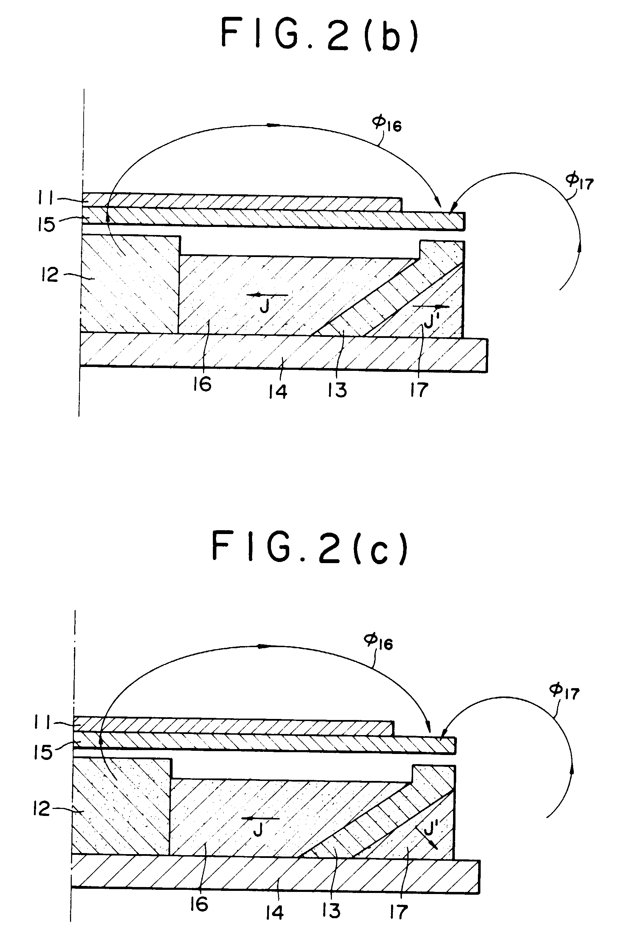

The magnetron sputtering apparatus shown in Fig. 2(a) comprises an inner magnetic pole 12 composed of a soft magnetic material such as steel; and outer magnetic pole 13 disposed so as to enclose the inner magnetic pole 12; a permanent magnet 16 having magnetization predominantly in one horizontal direction with respect of the target 11 disposed between the inner and outer magnetic poles 12, 13; and a permanent magnet 17 having magnetization predominantly in the horizontal direction opposite to that of the permanent magnet 16, disposed on the outer side surface of the outer magnetic pole 13, wherein the magnetic flux density is high around the outer magnetic pole 13. As a result, in the case of a large-scale magnetron or in the case where a ferromagnetic material is used for target 11, a strong magnetic field is produced over the target 11 and the plasma is retained easily, thereby increasing the sputtering rate significantly as compared with a usual magnetron.

As shown in Fig. 2(b), the outer magnetic pole 13 may be a soft magnetic material disposed so as to be inclined towards the inside. In this case, it is particularly required to use a permanent magnet 17 having a high energy product, which is disposed outside the outer magnetic pole 13, in order to allow the outer magnetic pole 13 to produce a sufficiently great magnetic flux density. However, this structure provides the advantage that the size of the magnetron can be smaller. In this case, as shown in Fig. 2(c), if the direction of magnetization of the permanent magnet 17 is perpendicular to that of the outer magnetic pole 13 disposed therewithin, the arrangement gives the effect of increasing the magnetic flux density of the outer magnetic pole 13. A permanent magnet 17 having this unusual shape can readily be assembled if a plastic magnet made e.g. of a rare earth metal which can be injection- or press-molded is used as the permanent magnet.

Referring back to Fig. 1, which shows another example of a magnetron sputtering apparatus according to the present invention, the soft magnetic body 8 is magnetized in the direction toward the outer magnetic pole by means of the magnetic field formed by the inner magnetic pole 2 and the outer magnetic pole 3. The magnetization acts over the upper surface of the target 11 in such a manner that the absolute value of the horizontal magnetic field and the gradient of the vertical magnetic field in the middle portion of both magnetic poles 12 and 13 are decreased.

On the other hand, the influence of the soft magnetic body 8 upon the magnetic field is so small that the gradient of the vertical magnetic field is increased around the upper portion of the two magnetic poles 12 and 13. The slits disposed on the soft magnetic body 8 serve to regulate the intensity of magnetization when the soft magnetic body 8 is magnetized by means of the magnetic field generated by the two magnetic poles. More specifically, it is considered that the disposition of the slits causes the magnetic flux to spring out in their positions, and the magnetic field to be generated in the opposite direction at the portions constituting the sections, thereby regulating the intensity of magnetization of the soft magnetic body. An accurate control of the distribution of the magnetic field over the upper surface of the target can be implemented by appropriately adjusting the width of the slits of the soft magnetic body 8 and controlling the intensity of magnetization at each section of the soft magnetic body 8.

In particular, when a ferromagnetic body is used as the target, adjustment of the slit widths is important. In a conventional magnetron using ferromagnetic material as the target, when erosion develops on the target, the magnetic flux is caused to spring out from the target itself as shown in Fig. 21 so that the magnetic field is increased at the site where erosion has developed, while this increased magnetic field decreases the magnetic field produced by the two magnetic poles on its both sides. Accordingly, the plasma is localized at the portion where erosion develops, and no plasma is caused to occur on its both sides. As a consequence, erosion proceeds with increasing velocity. When the target consisting of the ferromagnetic material develops, the magnetic field is increased under the back surface of the target as well as on the upper surface thereof. The soft magnetic body 8 used in preferred embodiments of invention has the function of preventing the magnetic field over the target from increasing as a result of an increase in magnetization of the soft magnetic body by means of the increased magnetic field. In order to have the soft magnetic body 8 serve its function well, it is necessary to optimize the magnetic characteristics of the soft magnetic body - in other words, the number of the sections of the soft magnetic body or the width of the slits disposed thereon - in accordance with the magnetic characteristics of the target or the thickness of the target. As there are gaps between the sections of the soft magnetic body 8, the gaps have the effect of adjusting the magnetic characteristics of the soft magnetic body.

For targets composed of non-magnetic materials, no influence is given upon the distribution of the magnetic field by development of erosion. An appropriate adjustment of the widths of the slits permits an accurate distribution of the magnetic field over the target. This adjustment is advantageous because its adjustment is simple. It is to be noted that the slits are not necessarily entirely separate, and they may partially be connected to each other. In both cases, there is no significant difference of the effect. The thickness, length and magnetic characteristics of each section of the soft magnetic body are not necessarily the same as each other and they may vary as needed.

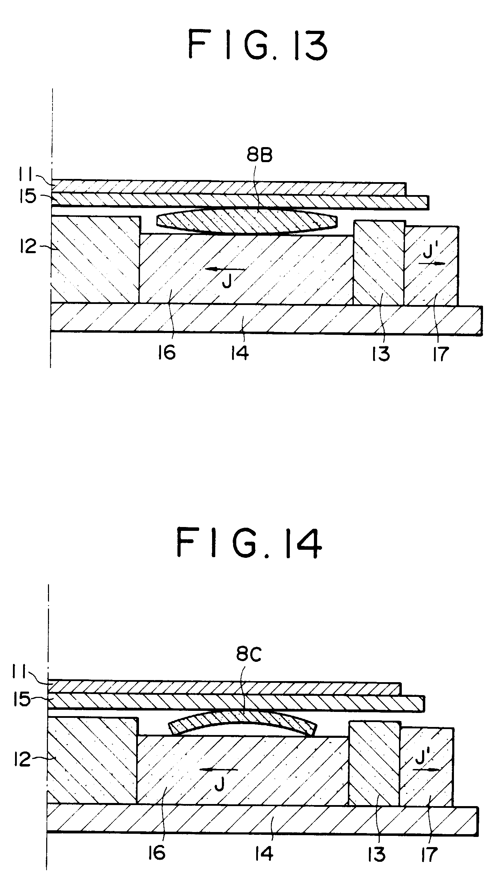

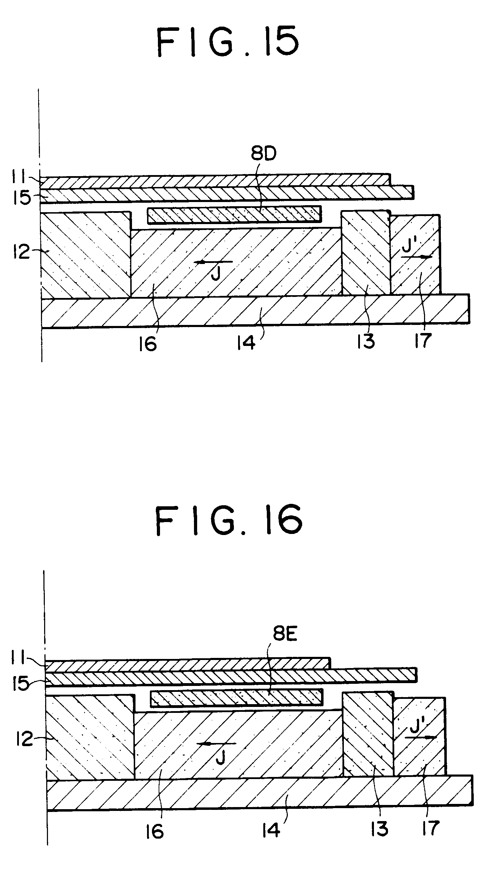

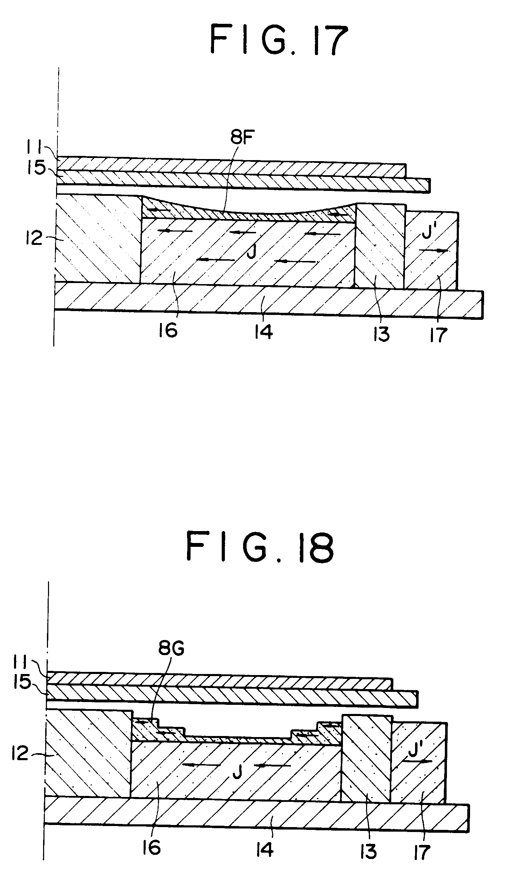

In the example as shown in Fig. 13, the soft magnetic body 8B is smaller in cross-sectional area at both end portions so that the amount of the magnetic flux is decreased at both end portions. In the examples as shown in Fig. 14, the soft magnetic body 8C is disposed so as to allow both end portions to be farther from the target surface so that the magnetic field varies continuously from the portion where the gradient of the vertical magnetic field is small to the portion where the gradient of the vertical magnetic field is large, compared with the former case. This example has the characteristic that periodical changes in the sputtering rate can be small in particular when the target is of ferromagnetic material. In the examples shown in Figs. 15 and 16, magnetic bodies 8D and 8E are composed of steel or the like, which is in plate form. In the example of Fig. 17, there is used a permanent magnet 8F which has magnetization predominantly in the horizontal direction and is curved in such a concave shape as its thickness is thinner at its central portion and continuously thicker as the distance comes closer to its side portions. The permanent magnet 8F is disposed so as to allow its concave surface to face the back surface of the target. As shown in Fig. 18, a permanent magnet 8G is disposed in substantially the same manner as the permanent magnet 8F as shown in Fig. 17, except for its concave face which is indented from its side end portions in a stepwise form. This example has substantially the same effect as the example as shown in FIG. 17. In these apparatuses, the action of compensating the magnetic field is small if the target is of ferromagnetic material as described hereinabove; however, they can be used in case of the target of non-magnetic material, thereby enabling the setting of the distribution of the magnetic field. Referring back to FIG. 16, the outer magnet 13 is arranged so as to allow its outer periphery to project over the outer circumference of the target 11. This arrangement, however, can be applied when a magnet 17 disposed outside the outer magnetic pole 13 has a sufficiently large energy product or when the magnet 17 has a sufficient thickness. In this case, the sputtering region can be spread over the outer periphery of the target.

Referring now to FIG. 1, it is seen that the magnetic body 8 composed of steel or the like is mounted on the back side of the target in a position between the two magnetic poles. Its section has substantially the same as that taken along line P_{A} - P_{B} in FIG. 20. As shown in FIG. 1, reference numerals 12 and 13 denote inner and outer magnetic poles, respectively, each consisting of soft magnetic material. A permanent magnet 16 having horizontal magnetization J is mounted between the two magnetic poles and a permanent magnet 17 having magnetization J' opposite to the magnetization J is stuck to the outer surface of the outer magnetic pole. It is to be noted herein that the magnetization may be deviated to some extent from its horizontal direction as long as its main component of the magnetization is substantially horizontal and opposite to that of the other magnetization as shown in FIG. 1. The inner and outer magnetic poles 12 and 13 may be of a permanent magnet having magnetization in the vertical direction; however, the energy product of such a permanent magnet varies so that magnetic material such as steel is preferred in order to provide an accurate distribution of the magnetic field. In particular, when the outer magnetic pole 13 requires a uniformity of the magnetic flux density around its outer periphery, use of soft magnetic material is required. FIG. 1 shows the soft magnetic body 8A that is disposed in the magnetic field and divided into four sections by slits with a narrow width ranging usually from approximately 0.01 mm to 3 mm, preferably from approximately 0.10 mm to 0.5 mm. Thicknesses of the soft magnetic body 8 range usually from about 1 mm to 10 mm, preferably from about 4 mm to 8 mm. The soft magnetic body is fixed with a support plate 9 of non-magnetic material. In the drawing, reference numeral 14 stands for a base plate consisting of non-magnetic material and reference numeral 15 for a backing plate to which the target is stuck. In the first example of FIG. 1, there is used a target of ferromagnetic material such as FeCo, having diameter of 20,3 cm (8 inches) and thickness of 2.5 mm.

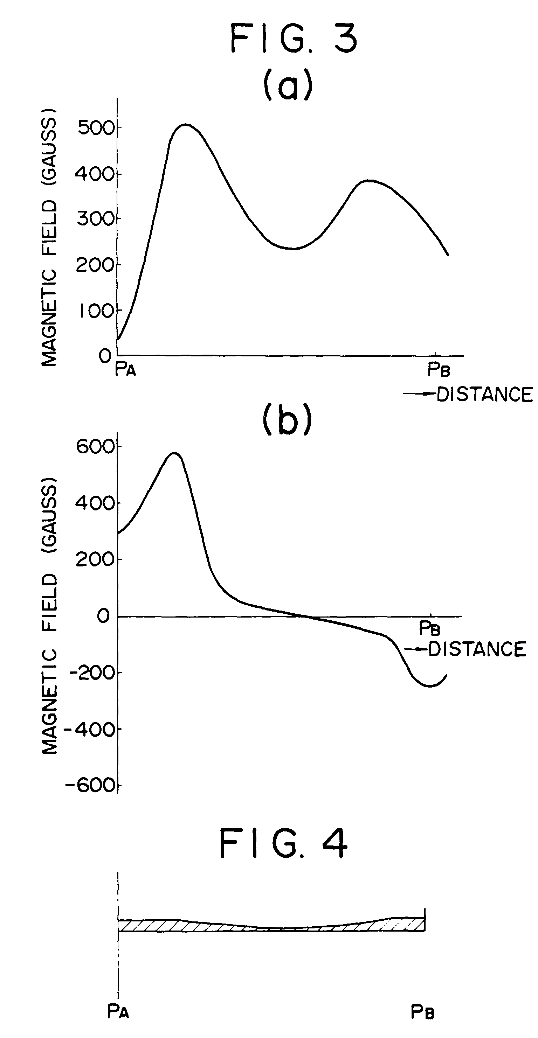

FIGS. 3(a) and 3(b) show patterns of distributions of the respective horizontal and vertical magnetic fields at 2 mm above the target surface prior to start of the sputtering when the target of ferromagnetic material is applied to the apparatus according to the present invention. FIG. 4 shows an erosion pattern of the target after the sputtering. FIGS. 22(a) and 22(b) show the same distribution patterns and FIG. 23 shows an erosion pattern in the same conditions, when the same target is applied to the conventional magnetron as shown in FIG. 19. As is apparent from FIGS. 22(a) and 22(b) and FIG. 23, erosion occurs locally for the conventional magnetron and it develops with accelerated velocity. Furthermore, it is found that the region where plasma is closed gets narrower as the erosion develops, thereby rapidly decreasing the sputtering rate as time passes. On the contrary, for the magnetron sputtering apparatus according to the present invention, erosion occurs in a wide region and the soft magnetic body 8 compensates the distribution of the magnetic field over the target as the erosion develops, thereby making a periodical variation in the sputtering rate extremely small. In the example of FIGS. 3(a), 3(b) and 4, the gradient of the vertical magnetic field around the outer magnetic pole is set to approximately 350 Gauss/cm (1 Gauss = 10⁻⁴ T) and the gradient thereof at a central portion between the two magnetic poles is set to approximately 20 Gauss/cm. Further, it is set that polarity of the vertical magnetic field changes at a portion where the gradient of the vertical magnetic field is small - in this case, in a position extremely close to the position indicating the minimum value of an M-shaped horizontal magnetic field. In the distribution of the vertical magnetic field as shown in FIG. 3(b), the magnetic field is set to be the highest around the outside of the inner magnetic pole and to be smaller at a central portion of the inner magnetic pole. In this case, as an upper portion of the inner magnetic pole is a portion where no plasma generates, the distribution of the magnetic field at this portion is outside the present invention. In this example, the target life is prolonged by larger than five times to approximately 55 kWh from approximately 10 kWh in terms of input power, compared with a conventional magnetron as shown in FIG. 19.

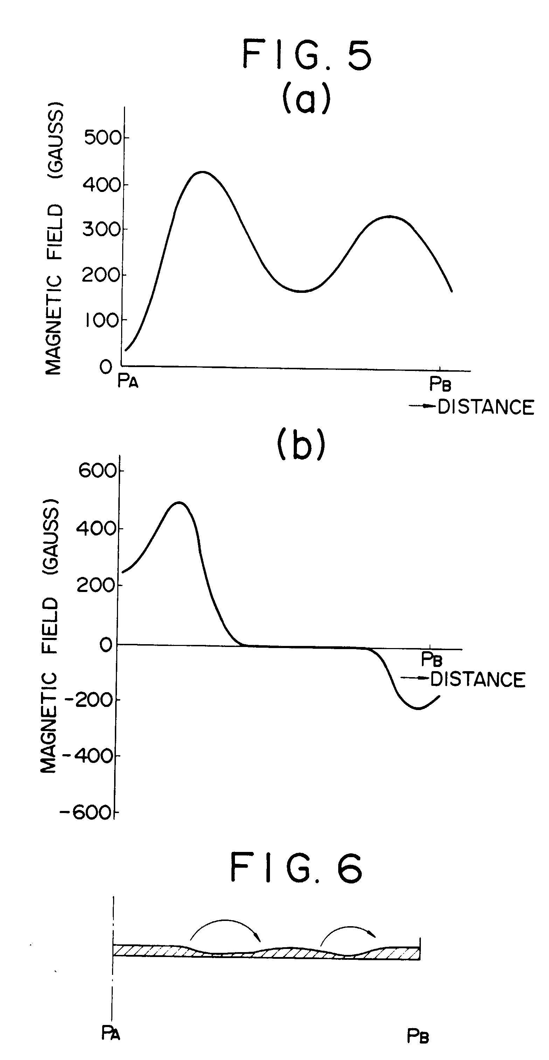

FIGS. 5(a), 5(b) and 6 represent the second example indicating the distributions of the magnetic field and an erosion pattern, respectively, wherein width of each slit of the soft magnetic body 8 is narrowed so as to make the gradient of the vertical magnetic field virtually null at a portion where the gradient of the vertical magnetic field between the magnetic poles is small. In this case, the erosion pattern is of a W-shaped form and the target life is approximately 30 kWh. This is because the erosion of the target develops with a slightly faster speed at a portion where a rise in the gradient of the vertical magnetic field is rapid and the action of compensating the magnetic field of the soft magnetic body 8 is not so large at that portion. Furthermore, it is considered to be based on the fact that plasma is confined by a partial loop of the magnetic flux from the target surface as shown in FIG. 6. Therefore, particularly when the target is of a ferromagnetic material, it is required that the gradient of the vertical magnetic field is optimized in accordance with magnetic characteristics of the target. The results of an experiment using a ferromagnetic material as the target, particularly having a large permeability, have revealed that a better result can be achieved when the gradient of the vertical magnetic field is set to an appropriately small value than when the gradient of the vertical magnetic field is set to zero. It is noted that a very good result cannot be obtained when the location where polarity of the vertical magnetic field is changed is set to the portion where the gradient of the vertical magnetic field is large and that further, when the location at which polarity of the vertical magnetic field is changed is set to a position extremely close to the position indicating the minimum value of the M-shaped horizontal magnetic field, the longest target life can be attained and a sputtering rate during operation changes at the smallest rate.

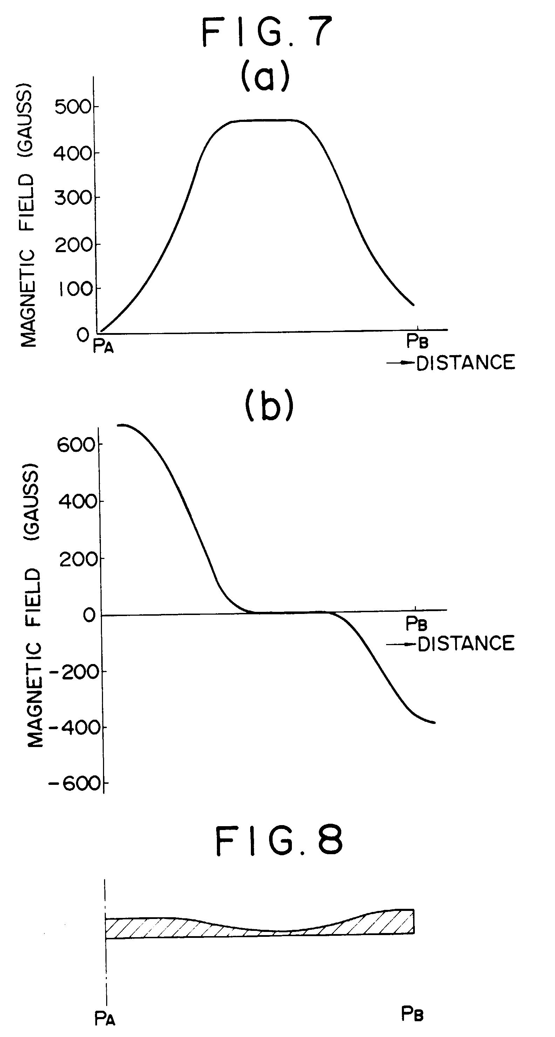

In the third example as shown in FIGS. 7(a), 7(b) and 8, there is used the target of a Ta non-magnetic material having a 20.3 cm (8-inch) diameter and a 6-mm thickness. FIGS. 7(a), 7(b) and 8 represent the distributions of the horizontal and vertical magnetic fields at 2 mm above the target surface prior to the start of sputtering and an erosion pattern of the target subsequent to sputtering, respectively.

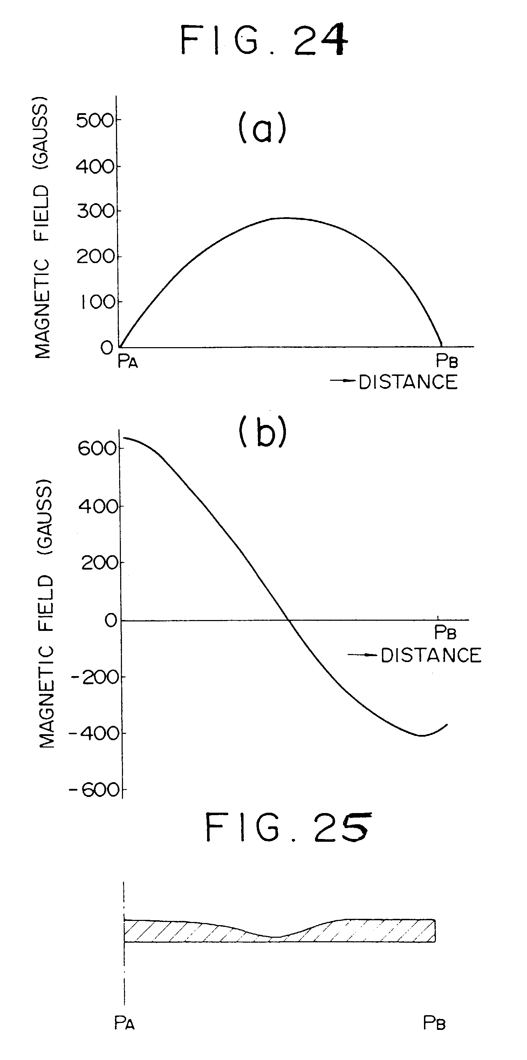

FIGS. 24(a), 24(b) and 25 represent the respective distributions of the horizontal and vertical magnetic fields at 2 mm above the target surface prior to the start of sputtering and an erosion pattern of the target subsequent to sputtering, respectively, using the same target as in the third example for a conventional magnetron as shown in Figure 19. As is apparent from Figs. 24(a), 24(b) and 25, erosion occurs locally on the target of non-magnetic material when used with the conventional magnetron, although not so large as with the target of ferromagnetic material. In this case, a utilization efficiency of the target is approximately 25%.

In the example of FIG. 7, the soft magnetic body 8 consists of three sections and it accounts for approximately 50% of the distance between its two magnetic poles. As shown in FIGS. 7(a) and 7(b), the gradient of the vertical component of the magnetic field is set to zero at a central portion between the two magnetic poles while the gradient of the horizontal component of the magnetic field is set to a constant value. In this case, erosion occurs to a larger extent at the central portion between the magnetic poles although an erosion area spreads, as is apparent in FIG. 8. In this example, the erosion pattern is a loose U-shaped form and a utilization efficiency of the target is 41%.

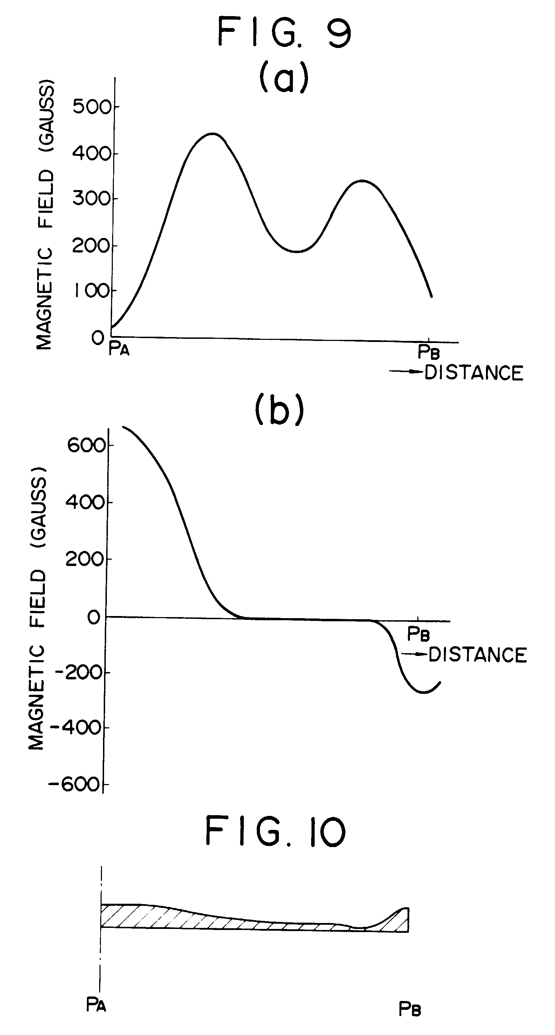

In the fourth example, the soft magnetic body 8 consists of five sections and the length of the magnetic body 8 accounts for approximately 80% of the distance between the two magnetic poles. An experiment has been conducted using the target wherein the gradient of the vertical magnetic field is set to zero at a central portion between the two magnetic poles and the horizontal component of the magnetic field is in an M-shaped form therebetween, as shown in FIGS. 9(a) and 9(b), provided however that the maximum value of the horizontal component at the central portion is set to approximately 50%. In this case, as is apparent from FIG. 10, it has been found that erosion develops in an extremely wide region and a utilization efficiency of the target is 52%. It is noted herein that erosion develops to a somewhat larger extent at a portion close to the outer magnetic pole where the gradient of the vertical magnetic field rapidly rises.

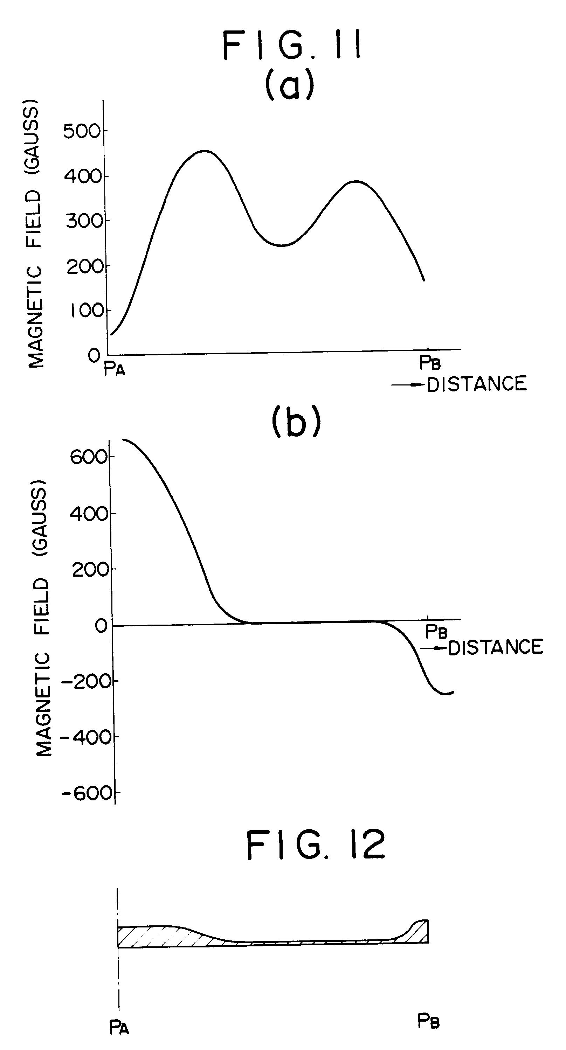

Thus, in the fifth example, the distribution of the magnetic field is set so as to allow the gradient of the vertical magnetic field to gradually rise at that portion. In this case, the width of the slit between two outer sections of the soft magnetic body 8 as shown in the fourth example is somewhat extended from 0.2 mm to 0.3 mm. The distributions of the magnetic field and an erosion pattern in this case are shown in FIGS. 11(a) and 11(b) and FIG. 12, respectively. In this case, the utilization efficiency further rises to 66%.

Although these experimental results cannot clearly be explained theoretically, it is considered that, when the plasma is confined within a dome-like magnetic field, the magnetic field nearly parallel to the target surface can be provided around a central portion between the two magnetic poles yet the plasma is thrust toward the central portion from the both sides by a larger magnetic pressure around the two magnetic poles due to a larger magnetic flux density in the vicinity of the magnetic poles, thereby making the electron concentration denser around the central portion between the two magnetic poles. In order to realize an extremely wide erosion region, thus it is considered that the magnetic flux density be somewhat smaller around the central portion between the two magnetic poles, thereby permitting the electrons to depart to some extent from the central portion.

Some experimental results have revealed that, in instances where the gradient of the vertical magnetic field is set to nearly zero, there are many occasions where an erosion distribution is changed to a nearly flat state from the U-shaped state when the distribution of intensity of the horizontal magnetic field is such that the maximum value at the central portion between the two magnetic poles ranges from approximately 20% to 75%.

It is provided, however, that there has been seen the tendency that plasma becomes unstable when the minimum value of the M-shaped horizontal magnetic field is lowered to 70 Gauss or smaller. Therefore, it is required that the minimum value for the horizontal component of the magnetic field at the central portion between the magnetic poles be 70 Gauss, preferably larger than 150 Gauss. As is apparent from the experimental results as shown in FIGS. 9 and 10, a variation in curvature of the magnetic field also is a significant factor and it is preferred that changes in the gradient of the magnetic field from a small state to a great state are not sharp.

Furthermore, it is noted that the utilization efficiency of the target cannot rise to a very high extent merely by making the direction of the magnetic field over the target parallel to the target surface, and it is thus required that the distribution of the magnetic field be optimized by observing an erosion distribution of the target.

In adjusting the width of the slit between the sections of the soft magnetic body as have been described hereinabove, it presents the advantage that the slits are disposed in somewhat larger width in advance and soft steel or the like in a ribbon form is inserted into the slits, because this technique does not require that a large number of sections of the soft magnetic body 8A be prepared. It is also preferred that an appropriate substance having a small non-permeability, such as Cu, Al or stainless steel, or a permanent magnet having no magnetization yet a high coercive force may be inserted into the slit without leaving the slit merely as a gap, in order to permit ready positioning of the sections of the soft magnetic body 8A.

As have been described hereinabove, the magnetron sputtering apparatus according to the present invention is provided with the inner magnetic pole consisting of a permanent magnet having magnetization in the vertical direction or a soft magnetic material, an outer magnetic pole consisting of a similar material and disposed so as to enclose the inner magnetic pole, a permanent magnet having magnetization predominantly in the horizontal direction and disposed between the inner and outer magnetic poles, and a magnet having magnetization predominantly in a direction opposite to the horizontal direction of the permanent magnet. Thus the apparatus according to the present invention has a sufficiently large degree of the magnetic flux around the outer magnetic pole, thereby permitting plasma to be readily retained in case of a large-scale magnetron or in case where the target is of a ferromagnetic material, and thereby increasing the sputtering rate to a considerable extent, as compared with a usual magnetron.

Furthermore, the magnetron sputtering apparatus according to the present invention is provided on a back side of the target between the inner and outer magnetic poles with a means for decreasing a component of the leakage magnetic field, vertical to the target, from the inner and outer magnetic poles over a surface of the target disposed on the inner magnetic pole and a magnetic pole in the vicinity of the outer magnetic pole, at a central portion between the inner and outer magnetic poles, yet increasing the vertical component thereof at a portion around the magnetic poles, and for making the distribution of intensity of the horizontal component of the magnetic field in an M-shaped form between the magnetic poles. The provision of such a means on the back side of the target between the inner and outer magnetic poles serves as avoiding local erosion of the target and prolonging the target life to a considerable extent. In case of the target of ferromagetic material, a variation in the sputtering rate can be minimized.

As a magnetic-field generating means as described hereinabove is so strong, a magnetron sputtering apparatus according to the present invention which permits a ready retention of the plasma and has a wide sputtering area can be provided by combining it with a means using the soft magnetic material having effects on the magnetic field over the upper target surface or with a means using the permanent magnet.

## Claims

1. A magnetron sputtering apparatus comprising an inner magnetic pole (12), an outer magnetic pole (13) having a polarity opposite to that of the inner magnetic pole (12) and arranged to surround the inner magnetic pole (12), a target (11) disposed at least above the inner magnetic pole (12) and extending therefrom towards the outer magnetic pole (13), each of the magnetic poles (12, 13) comprising a permanent magnet having magnetization in a direction perpendicular to the plane of the target (11), of a soft magnetic material, and a first permanent magnet (16) having magnetization in a direction parallel to the plane of the target (11) disposed between the inner and outer magnetic poles (12, 13), characterised in that a second permanent magnet (17) having magnetization predominantly in a direction opposite to the direction of the magnetization in the first permanent magnet (16) is disposed on an outer side of the outer magnetic pole (13).

2. A magnetron sputtering apparatus as claimed in Claim 1, further comprising means (8;8B;8C;8D;8E;8F;8G) disposed between the first permanent magnet (16) and the target (11), between the inner and outer magnetic poles and adapted: (a) to decrease, at a central portion between the inner (12) and outer (13) magnetic poles, the component in the direction perpendicular to the plane of the target of the magnetic field at the surface of the target and generated by the inner (12) and outer (13) magnetic poles and emerging from the surface of the target (11); (b) to increase the said component in the direction perpendicular to the plane of the target at a portion around the magnetic poles (12, 13); and (c) to cause the distribution of intensity of the component in the direction parallel to the plane of the target of the magnetic field between the magnetic poles to adopt an M-shaped form, having peaks towards the magnetic poles (12, 13) and a trough therebetween.

3. A magnetron sputtering apparatus as claimed in Claim 2, wherein said means (8) comprises a soft magnetic material divided into plural discrete sections (8) by an interposed substance having a low permeability, or by slits, the number of the sections of the soft magnetic material and the width of the low permeability substance or the slits being determined in accordance with the magnetic characteristics and the thickness of the target (11).

4. A magnetron sputtering apparatus as claimed in Claim 2, wherein said means (8B) comprises a soft magnetic material (8B) having, when considering its cross-section, a sectional area that is relatively large at its central portion and becomes gradually smaller towards the end portions near the magnetic poles.

5. A magnetron sputtering apparatus as claimed in Claim 2, wherein said means (8C) comprises a soft magnetic material (8C) which, when considering its cross-section, is curved and disposed so as to be further from the target (11) at its end portions nearest the magnetic poles (12, 13) than it is at a portion therebetween.

6. A magnetron sputtering apparatus as claimed in Claim 2, wherein said means (8D; 8E) comprises a soft magnetic material (8D; 8E), when considering its cross-section, in the form of a plate having a width which accounts for 20% to 80% of the distance between the inner and outer magnetic poles (12, 13).

7. A magnetron sputtering apparatus as claimed in Claim 2, wherein said means (8F; 8G) comprises a permanent magnet (8F; 8G) which has magnetization predominantly in the direction parallel to the plane of the target and which, when considering its cross-section, is arranged so as to be further from the target (11) at its central portion and to become gradually closer to the target towards its end portions nearest the magnetic poles (12, 13).

8. A magnetron sputtering apparatus as claimed in any of Claims 2 to 7 wherein the distribution of intensity of the component in the direction parallel to the plane of the target of the magnetic field in said M-shaped form is arranged such that its minimum value at the central portion between the magnetic poles (12, 13) is between 20% and 75% of its maximum value.

9. A magnetron sputtering apparatus as claimed in any of Claims 2 to 8 wherein the change in polarity of the component in the direction perpendicular to the plane of the target of the magnetic field between the magnetic poles (12, 13) occurs at a position between the magnetic poles (12, 13) where the gradient of said component in the direction perpendicular to the plane of the target is small.

10. A magnetron sputtering apparatus as claimed in any of Claims 2 to 9 wherein the change in polarity of the component in the direction perpendicular to the plane of the target of the magnetic field occurs at a position between the magnetic poles (12, 13) in the vicinity of the position of the minimum value of the component in the direction parallel to the plane of the target in said trough of said M-shaped distribution form.

11. A magnetron sputtering apparatus as claimed in Claim 10, wherein said vicinity is defined as the actual position of the minimum value of the component in the direction parallel to the plane of the target plus or minus 10% of the distance between the magnetic poles (12, 13).

12. A magnetron sputtering apparatus as claimed in Claim 3, wherein a soft magnetic material in the form of a ribbon is inserted into the slits to adjust the width of the slits.

13. A magnetron sputtering apparatus as claimed in any of Claims 1 to 5 or 8 to 12, wherein the target (11) is of ferromagnetic material.

## Patentansprüche

1. Magnetronzerstäubungsanlage, die einen inneren Magnetpol (12) umfasst, einen äußeren Magnetpol (13) mit einer Polarität, die derjenigen des inneren Magnetpols (12) entgegengesetzt ist, und der angeordnet ist, um den inneren Magnetpol (12) zu umgeben, ein Target (11), das wenigstens über dem inneren Magnetpol (12) angeordnet ist, und sich davon auf den äußeren Magnetpol (13) hinzu erstreckt, wobei jeder Magnetpol (12, 13) einen Permanentmagneten mit Magnetisierung in einer Richtung senkrecht zur Ebene des Targets (11) aus einem weichmagnetischen Material umfasst, und einen ersten Permanentmagneten (16) mit Magnetisierung in einer Richtung parallel zur Ebene des Targets (11), der zwischen den inneren und äußeren Magnetpolen (12, 13) angeordnet ist, dadurch gekennzeichnet, daß ein zweiter Permanentmagnet (17) mit Magnetisierung hauptsächlich in einer Richtung entgegengesetzt zur Richtung der Magnetisierung in dem ersten Permanentmagneten (16) auf einer äußeren Seite des äußeren Magnetpols (13) angeordnet ist.

2. Magnetronzerstäubungsanlage nach Anspruch 1, die weiterhin ein Mittel (8;8B;8C;8D;8E;8F;8G) umfasst, das zwischen dem ersten Permanentmagneten (16) und dem Target (11) zwischen den inneren und äußeren Magnetpolen angeordnet ist, und das angepaßt ist, um: (a) an einem mittleren Teil zwischen den inneren (12) und den äußeren (13) Magnetpolen die Komponente in der Richtung senkrecht zur Ebene des Targets des Magnetfeldes an der Oberfläche des Targets, und das von den inneren (12) und äußeren (13) Magnetpolen erzeugt wird, und von der Oberfläche des Targets (11) austritt, zu verringern; (b) die besagte Komponente in der Richtung senkrecht zur Ebene des Targets an einem Teil um den Magnetpolen (12, 13) zu erhöhen; und (c) die Verteilung der Intensität der Komponente in der Richtung parallel zur Ebene des Targets des Magnetfeldes zwischen den Magnetpolen zu verursachen, um eine M-förmige Gestalt anzunehmen, die Spitzenwerte auf die Magnetpole (12, 13) hinzu hat, und einen Tiefpunkt dazwischen.

3. Magnetronzerstäubungsanlage nach Anspruch 2, in der das Mittel (8) ein weichmagnetisches Material umfasst, das durch eine zwischengelagerte Substanz mit geringer Permeabilität, oder durch Schlitze in viele diskrete Abschnitte (8) aufgeteilt ist, wobei die Anzahl von Abschnitten des weichmagnetischen Materials und die Breite der Substanz geringer Permeabilität oder der Schlitze in Übereinstimmung mit der magnetischen Kennzeichnung und der Dicke des Targets (11) bestimmt ist.

4. Magnetronzerstäubungsanlage nach Anspruch 2, in der das Mittel (8B) ein weichmagnetisches Material (8B) umfasst, das, wenn man seinen Querschnitt betrachtet, ein Schnittgebiet hat, das an seinem mittleren Teil relativ groß ist, und auf die Endteile in der Nähe der Magnetpole hinzu allmählich kleiner wird.

5. Magnetronzerstäubungsanlage nach Anspruch 2, in der das Mittel (8C) ein weichmagnetisches Material (8C) umfasst, das, wenn man seinen Querschnitt betrachtet, gekrümmt ist, und so angeordnet ist, daß es an seinen Endteilen in der Nähe der Magnetpole (12, 13) von dem Target (11) weiter entfernt ist als an einem Teil dazwischen.

6. Magnetronzerstäubungsanlage nach Anspruch 2, in der das Mittel (8D; 8E) ein weichmagnetisches Material (8D; 8E) umfasst, wenn man seinen Querschnitt betrachtet, in Gestalt einer Platte mit einer Breite, die 20% bis 80% der Entfernung zwischen den inneren und äußeren Magnetpolen (12, 13) ausmacht.

7. Magnetronzerstäubungsanlage nach Anspruch 2, in der das Mittel (8F; 8G) einen Permanentmagneten (8F; 8G) umfasst, der Magnetisierung hauptsächlich in der Richtung parallel zur Ebene des Targets hat, und der, wenn man seinen Querschnitt betrachtet, so angeordnet ist, daß er an seinem mittleren Teil weiter von dem Target (11) entfernt ist, und auf seine Endteile in der Nähe der Magnetpole (12, 13) hinzu allmählich näher an das Target geht.

8. Magnetronzerstäubungsanlage nach einem der Ansprüche 2 bis 7, in der die Verteilung der Intensität der Komponente in der Richtung parallel zur Ebene des Targets des Magnetfeldes in der M-förmigen Gestalt so angeordnet ist, daß sein Minimalwert an dem mittleren Teil zwischen den Magnetpolen (12, 13) zwischen 20% und 75% seines Maximalwerts ist.

9. Magnetronzerstäubungsanlage nach einem der Ansprüche 2 bis 8, in der die Änderung der Polarität der Komponente in der Richtung senkrecht zur Ebene des Targets des Magnetfeldes zwischen den Magnetpolen (12, 13) an einer Stellung zwischen den Magnetpolen (12, 13) stattfindet, an der der Gradient der Komponente in der Richtung senkrecht zur Ebene des Targets klein ist.

10. Magnetronzerstäubungsanlage nach einem der Ansprüche 2 bis 9, in der die Änderung der Polarität der Komponente in der Richtung senkrecht zur Ebene des Targets des Magnetfeldes an einer Stellung zwischen den Magnetpolen (12, 13) in der Nachbarschaft der Stellung des Minimalwerts der Komponente in der Richtung parallel zur Ebene des Targets in dem Tiefpunkt der M-förmigen Verteilungsgestalt stattfindet.

11. Magnetronzerstäubungsanlage nach Anspruch 10, in der die Nachbarschaft als die tatsächliche Stellung des Minimalwerts der Komponente in der Richtung parallel zur Ebene des Targets plus oder minus 10% der Entfernung zwischen den Magnetpolen (12, 13) definiert ist.

12. Magnetronzerstäubungsanlage nach Anspruch 3, in der ein weichmagnetisches Material in Gestalt eines Bandes in die Schlitze eingeschoben wird, um die Breite der Schlitze einzustellen.

13. Magnetronzerstäubungsanlage nach einem der Ansprüche 1 bis 5 oder 8 bis 12, in der das Target (11) aus ferromagnetischem Material besteht.

## Revendications

1. Dispositif de pulvérisation magnétron comportant un pôle magnétique intérieur (12), un pôle magnétique extérieur (13), ayant une polarité opposée à celle du pôle magnétique intérieur (12) et agencé pour entourer le pôle magnétique intérieur (12), une cible (11) étant disposée au minimum au dessus du pôle magnétique intérieur (12) et s'allongeant à partir de là vers le pôle magnétique extérieur (13), chacun des pôles magnétiques (12, 13) comportant un aimant permanent dont la magnétisation se dirige en sens perpendiculaire au plan de la cible (11), en matière magnétique douce, et un premier aimant permanent (16) ayant une magnétisation en sens parallèle au plan de la cible (11) disposée entre les pôles magnétiques intérieur et extérieur (12, 13), caractérisé en ce qu'un deuxième aimant permanent (17) ayant une magnétisation dirigée principalement en sens opposé au sens de la magnétisation du premier aimant permanent (16) est disposé sur un côté extérieur du pôle magnétique extérieur (13).

2. Dispositif de pulvérisation magnétron tel que revendiqué à la revendication 1, comportant aussi des moyens (8;8B;8C;8D;8E;8F;8G) disposés entre le premier aimant permanent (16) et la cible (11), entre les pôles magnétiques intérieur et extérieur et adaptés: (a) pour diminuer, en une portion centrale entre les pôles magnétiques intérieur (12) et extérieur (13), l'élément en sens perpendiculaire au plan de la cible du champ magnétique en surface de cible et généré par les pôles magnétiques intérieur (12) et extérieur (13) et ressortant de la surface de la cible (11); (b) pour augmenter ledit élément en sens perpendiculaire au plan de la cible en une portion autour des pôles magnétiques (12, 13); et (c) pour provoquer la distribution d'intensité de l'élément en sens parallèle au plan de la cible du champ magnétique entre les pôles magnétiques pour adopter une forme en M, dont les crêtes se dirigent vers les pôles magnétiques (12,13) avec un creux entre les deux.

3. Dispositif de pulvérisation magnétron tel que revendiqué à la revendication 2, dont lesdits moyens (8) comportent une matière magnétique douce divisée en plusieurs sections discrètes (8) par une substance interposée de faible perméabilité, ou par des fentes, le nombre de sections de matière magnétique douce et la largeur de la substance de faible perméabilité étant définie en conformité avec les caractéristiques magnétiques et l'épaisseur de la cible (11).

4. Dispositif de pulvérisation magnétron tel que revendiqué à la revendication 2, dont lesdits moyens (8B) comportent une matière magnétique douce (8B), ayant par rapport à sa coupe, une surface de section qui s'avère relativement large en sa portion centrale et devient progressivement plus petite vers les portions d'extrémité à proximité des pôles magnétiques.

5. Dispositif de pulvérisation magnétron tel que revendiqué à la revendication 2, dont lesdits moyens (8C) comportent une matière magnétique douce (8C), dont la forme par rapport à sa coupe est curviligne et disposée de telle façon à se trouver plus éloignée de la cible (11) en ses portions extrêmes proches des pôles magnétiques qu'elle ne l'est en une portion entre les deux.

6. Dispositif de pulvérisation magnétron tel que revendiqué à la revendication 2, dont lesdits moyens (8D; 8E) comportent une matière magnétique douce (8D; 8E), sont sous forme de plaque d'une largeur représentant 20% à 80% de la distance entre les pôles magnétiques intérieur et extérieur (12,13).

7. Dispositif de pulvérisation magnétron tel que revendiqué à la revendication 2, dont lesdits moyens (8F; 8G) comportent un aimant permanent (8F; 8G) dont la magnétisation est principalement en sens parallèle au plan de la cible, lorsque par rapport à sa coupe, elle est agencée de telle façon à se trouver plus éloignée de la cible (11) en sa portion centrale et à se rapprocher progressivement de la cible vers ses extrémités les plus proches des pôles magnétiques (12, 13).

8. Dispositif de pulvérisation magnétron tel que revendiqué en l'une quelconque des revendications 2 à 7, dont la distribution de l'intensité de l'élément dans le sens parallèle au plan de la cible du champ magnétique dans ladite forme en MN est agencée de façon telle que sa valeur minimum en portion centrale entre les pôles magnétiques (12, 13) s trouve entre 20% et 75% de sa valeur maximum.

9. Dispositif de pulvérisation magnétron tel que revendiqué en l'une quelconque des revendications 2 à 8, dont la variation de la polarité en sens perpendiculaire au plan de la cible du champ magnétique entre les pôles magnétiques (12, 13) se manifeste en une position entre les pôles magnétiques (12, 13) dont la pente dudit élément en sens perpendiculaire au plan de la cible est faible.

10. Dispositif de pulvérisation magnétron tel que revendiqué en l'une quelconque des revendications 2 à 9, dont la variation de la polarité en sens perpendiculaire au plan de la cible du champ magnétique se manifeste en une position situées entre les pôles magnétiques (12, 13) à proximité de la position de valeur minimum de l'élément en sens parallèle au plan de la cible dans ledit creux de ladite forme de distribution en M.

11. Dispositif de pulvérisation magnétron tel que revendiqué à la revendication 10, dont ladite proximité est définie pour représenter la véritable position de valeur minimum de l'élément dans le sens parallèle au plan de la cible à plus ou moins de 10% près de la distance entre les pôles magnétiques (12, 13).

12. Dispositif de pulvérisation magnétron tel que revendiqué à la revendication 3, dont une matière magnétique douce sous forme de bande est introduite entre les fentes pour ajuster la largeur desdites fentes.

13. Dispositif de pulvérisation magnétron tel que revendiqué en l'une quelconque des revendications 1 à 5 ou 8 à 12, dont la cible (11) consiste de matière ferromagnétique.
